# EUROPÄISCHE PATENTSCHRIFT

(11) **EP 3 441 792 B1**
(45) Veröffentlichungstag und Bekanntmachung des Hinweises auf die Patenterteilung: **28.04.2021**
(21) Anmeldenummer: 18187327.4
(22) Anmeldetag: 03.08.2018
(51) Int. Cl.: G01T 1/16, G01R 33/00, G01T 1/164

(54) **ABSCHWÄCHUNGSKORREKTUR BEI DER EMISSIONSTOMOGRAPHIE UNTER BERÜCKSICHTIGUNG DER TATSÄCHLICH VORHANDENEN HARDWARE-KOMPONENTEN**
ATTENUATION CORRECTION IN EMISSION TOMOGRAPHY TAKING INTO ACCOUNT THE EXISTING HARDWARE COMPONENTS
CORRECTION D'ATTÉNUATION DANS UNE TOMOGRAPHIE PAR ÉMISSION, COMPTE TENU DES COMPOSANTS MATÉRIELS RÉELLEMENT PRÉSENTS

(30) Priorität: 09.08.2017 DE 102017213874
(43) Veröffentlichungstag der Anmeldung: 13.02.2019
(73) Patentinhaber: Bruker BioSpin MRI GmbH, 76275 Ettlingen (DE)
(72) Erfinder: HUGGER, Thimo, 76337 Waldbronn (DE); JUNGE, Sven, 76275 Ettlingen (DE)
(74) Vertreter: Kohler Schmid Möbus Patentanwälte

(56) Entgegenhaltungen:
- WO-A2-2010/097714
- DE-A1-102007 044 874
- DE-A1-102010 024 139
- DE-A1-102013 104 720

## Beschreibung

Die Erfindung betrifft ein Verfahren zur Erzeugung einer Abschwächungskorrekturkarte mittels eines Computers zur Kompensation von Bildfehlern in der Emissionstomographie aufgrund vorhandener Hardwarekomponenten innerhalb des Bildgebungsvolumens eines Emissionstomographen.

Ein solches Verfahren ist bekannt geworden aus der US 2014/0221817 A1 (=Referenz [1]).

### Hintergrund der Erfindung

Die Verfahren der Emissions-Tomographie, wie etwa die Positronen-Emissions-Tomographie (PET) oder die Einzelphotonen-Emissionscomputertomographie (SPECT), sind verbreitete Verfahren zur funktionellen Bildgebung. Bei einer Untersuchung wird einem biologischen Mess-Objekt beziehungsweise einer Untersuchungsperson eine schwach radioaktive Substanz verabreicht, deren Verteilung im Organismus beispielsweise mittels PET sichtbar gemacht wird. Dadurch können biochemische und physiologische Funktionen des Organismus abgebildet werden. Als Radiopharmaka werden in der Emissionstomographie dabei Moleküle verwendet, die mit einem Radionuklid markiert sind. Durch radioaktive Zerfälle kommt es letztlich zur Aussendung von hochenergetischen Photonen, deren Richtung und Energie mit einer Vielzahl an ringförmig um die Untersuchungsperson angeordneten Detektoren erfasst werden. Aus den registrierten Zerfallsereignissen wird auf die räumliche Verteilung des Radiopharmakons im Körperinneren geschlossen.

Beim Durchlaufen von Materie können die bei der Zerstrahlung entstandenen Photonen in ihrer Energie geschwächt, gestreut oder absorbiert werden, wobei die Wahrscheinlichkeit für diese Prozesse von der Pfadlänge durch die Materie, der Energie der Photonen und dem entsprechenden Absorptionskoeffizienten der Materie abhängt. Dementsprechend ist in der PET eine Korrektur bezüglich der Abschwächung durch Komponenten, die sich im Strahlengang befinden, notwendig, wenn man Aussagen über die tatsächliche Strahlungsdosis machen möchte. Die Korrektur der Abschwächung der Strahlung erfordert die Kenntnis der Lage der abschwächenden Strukturen, die bei der Rekonstruktion von PET-Bilddaten mittels einer Abschwächungskorrekturkarte (attenuation map) berücksichtigt werden.

Die Problematik der Photonenabschwächung ist nicht nur auf PET beschränkt, sondern betrifft die Emissionstomographie im Allgemeinen. Darunter fällt z.B. auch die oben bereits erwähnte Einzelphotonen-Emissions-Computertomographie (SPECT).

Die unterschiedlichen Gewebestrukturen im Körper des Organismus, (Knochen, Fettgewebe, Luft in der Lunge, etc.) spielen hierbei eine zentrale Rolle, da diese unterschiedlichen Strukturen auch unterschiedliche Abschwächungskoeffizienten haben.

Die Emissionstomographie alleine hat den Nachteil, dass sie nur in geringem Maße Information über die innere Struktur des Untersuchungsobjekts liefert. Sie wird daher oftmals mit einer zusätzlichen Modalität kombiniert, etwa mit der Computertomographie (CT) oder der Magnetresonanztomographie (MRT). Da CT und MRT sehr unterschiedliche Vorteile besitzen, sind sowohl kombinierte PET-CT als auch kombinierte PET-MRT-Geräte gebräuchlich.

Die zusätzliche Modalität wird in der Regel auch zur Erstellung besagter Abschwächungskorrekturkarte verwendet. Im Beispiel mit der MRT ist dies technisch schwierig, da es keinen direkten Zusammenhang zwischen den MRT-Bilddaten und den Abschwächungskoeffizienten gibt.

Beispielsweise werden daher bei MRI-PET-Geräten z.B. SegmentierungsVerfahren eingesetzt um die mit der MRI aufgenommenen Gewebestrukturen zu identifizieren und daraus eine Schwächungskorrekturkarte zu erstellen, welche den segmentierten Gewebearten die zugehörigen Abschwächungskoeffizienten zuweist. Beispielsweise die US 8,724,875 B2 (=Referenz [2]) beschreibt ein solches Verfahren.

Problematisch sind allerdings auch bei einer MRI-Aufnahme schwer detektierbare oder gar unsichtbare Hardwarekomponenten, beispielsweise der Tierliege in der präklinischen Bildgebung, welche zur Abschwächung der Photonenintensität beitragen. Für diese können auf herkömmlichem Wege bisher keine Schwächungskorrekturkarten bestimmt werden.

Im Stand der Technik sind Verfahren bekannt, die Abschwächungskorrekturkarten der Hardware-Strukturen innerhalb des Probevolumens mittels direkter Verfahren wie z.B. CT aufnehmen und nachträglich mit der Schwächungskorrekturkarte, die mittels MRI-Bilddaten erstellt wurde, überlagern.

Die DE 10 2010 024 139 A1 (= Referenz [3]) beschreibt ein Verfahren zur Bestimmung einer Abschwächungskorrektur basierend auf zwei PET Messungen, die zur Erfassung und Kalibrierung der Strahlungsschwächung dienen soll.

Das Verfahren nach der DE 10 2007 044 874 A1 (= Referenz [4]) gleicht in wesentlichen Teilen dem Verfahren nach Referenz [3]. Auch hier wird ein Verfahren zur Erstellung einer Abschwächungskorrekturkarte beschrieben, die ähnlich wie in Referenz [3] die Zubehörteile mittels einer bildgebenden Messmethode bestimmt. In Referenz [4] wird jedoch mit keinem Wort ein CAD-Verfahren angedeutet.

Aus der DE 10 2012 214 012 A1 (= Referenz [5]) sind Verfahren zur Erzeugung einer Abschwächungskorrekturkarte bzw. Verfahren zur Durchführung einer Abschwächungskorrektur bekannt, die sich auf MRI-Bilddaten stützen.

Die eingangs zitierte US 2014/0221817 A1 (= Referenz [1]) befasst sich mit der Problematik der Abschwächung der Photonen durch die unterschiedlichen Hardwarekomponenten im Tomographen. Es wird vorgeschlagen, die Hardwarekomponenten optisch mittels eines Video-Überwachungssystems bzw. durch Lichtpulsmessungen (Kinect), oder durch kennzeichnen der Komponenten beispielsweise mit einem RFID-Transponder zu identifizieren um dann die entsprechende, vorgefertigte Schwächungskorrekturkarte z.B. aus einer Datenbank zu holen. Die Art und Weise wie diese Karten erzeugt werden, speziell die Generierung der Bauteile, ist in der Druckschrift nicht erwähnt.

### Aufgabe der Erfindung

Demgegenüber ist es Aufgabe der vorliegenden Erfindung, ein Verfahren der eingangs definierten Art mit vorhandenen oder zumindest leicht zugänglichen Mitteln vorzustellen beziehungsweise so zu modifizieren, dass damit auf einfache Weise sowie automatisierbar eine hochgradig genaue, möglichst rauschfreie und exakt reproduzierbare Schwächungskorrekturkarte für eine Schwächungskorrektur bei einem Emissionstomographie-Gerät unter Berücksichtigung der tatsächlich vorhandenen, bekannten HardwareKomponenten der Apparatur, welche einen wesentlichen Einfluss auf die Qualität der erzeugten Tomogramme haben, erstellt werden kann.

### Kurze Beschreibung der Erfindung

Diese Aufgabe wird wird auf ebenso überraschend einfache wie wirkungsvolle Weise dadurch gelöst, dass ein gattungsgemäßes Verfahren der eingangs genannten Art zumindest folgende Schritte umfasst:
(1.a) Anfertigen oder Bereitstellen eines oder mehrerer 3dimensionaler Computer-Aided-Design-(=CAD)-Modelle der zu kompensierenden Hardwarekomponenten;
(1.b) Konvertierung der benötigten Bauteile der CAD-Modelle in einen 3dimensionalen Bilddatensatz auf einem vorgegebenen Gitter zu Voxeln und Zuordnen eines Füllfaktors zu jedem Voxel;
(1.c) Punktweise Multiplikation des 3dimensionalen Bilddatensatzes eines jeden Bauteils mit dem jeweiligen bekannten Abschwächungskoeffizienten desjenigen Materials, aus dem das jeweilige Bauteil aufgebaut ist und derjenigen Energie, die der des verwendeten Emissionstomographie-Radiotracers entspricht; und
(1.d) Überlagerung der 3dimensionalen Bilddatensätze aller Bauteile der zu kompensierenden Hardwarekomponenten zu einer Abschwächungskorrekturkarte.

Im Rahmen der vorliegenden Erfindung ist unter dem Begriff CAD-Modell ein Computer-lesbares digitales 3dimensionales Modell zu verstehen, das mit CAD Programmen im engeren Sinn erstellt wird. Dem Fachmann sind jedoch auch andere Arten der Erstellung von digitalen 3-D-Modellen bekannt, die aber hier nicht genauer ausgeführt werden sollen.

Das erfindungsgemäße Verfahren wird typischerweise zur Erstellung einer Datenbank eingesetzt, welche die Abschwächungskorrekturkarten der gebräuchlichen Hardwarekomponenten beinhaltet. Eine Steuereinrichtung ist während des Betriebs so eingerichtet bzw. programmiert, dass die jeweils passenden Abschwächungskorrekturkarten der im Betrieb aktuell verwendeten Hardwarekomponenten selektiert werden und der, beispielsweise mittels MRT gemessenen, Abschwächungskorrekturkarte in geeigneter Weise überlagert werden kann.

### Bevorzugte Varianten der Erfindung

Ganz besonders bevorzugt sind Ausführungsformen des erfindungsgemäßen Verfahrens, die sich dadurch auszeichnen, dass die Bauteile in Schritt (1.b) in einem Zwischenschritt trianguliert werden. Auf diese Weise benötigt man einen geringeren Rechenaufwand sowie eine kürzere Berechnungsdauer des ausführenden Computerprogramms für die nachfolgende Voxelisierung. Im 3D Modell werden vorzugsweise Dreiecke verwendet, da dies die einfachste geometrische Flächenform ist.

Einer bevorzugte Klasse von Ausführungsformen der Erfindung betrifft ein Verfahren zur Durchführung einer Gesamt-Abschwächungskorrektur von Emissionstomographie-Bilddatensätzen gemäß Anspruch 3. Dieses Verfahren ist gekennzeichnet durch folgende Schritte:
(2.a1) Aufnahme eines 3dimensionalen tomographischen Datensatzes eines zu untersuchenden Objekts,
(2.a2) Erzeugung einer Abschwächungskorrekturkarte aus dem in Schritt (2.a1) erhaltenen 3dimensionalen tomographischen Datensatz
(2.b1) Bereitstellen einer oder mehrerer gemäß Anspruch 1 oder 2 gewonnener Abschwächungskorrekturkarten zur Kompensation von Bildfehlern in der Emissionstomographie aufgrund vorhandener Hardwarekomponenten innerhalb des Bildgebungsvolumens eines Emissionstomographen, umfassend folgende Schritte:
   (1.a) Anfertigen oder Bereitstellen eines oder mehrerer 3dimensionaler CAD-Modelle der zu kompensierenden Hardwarekomponenten,
   (1.b) Konvertierung der benötigten Bauteile der CAD-Modelle in einen 3dimensionalen Bilddatensatz auf einem vorgegebenen Gitter zu Voxeln und Zuordnen eines Füllfaktors zu jedem Voxel,
   (1.c) Punktweise Multiplikation des 3dimensionalen Bilddatensatzes eines jeden Bauteils mit dem jeweiligen bekannten Abschwächungskoeffizienten desjenigen Materials, aus dem das jeweilige Bauteil aufgebaut ist und derjenigen Energie, die der des verwendeten Emissionstomographie-Radiotracers entspricht; und
   (1.d) Überlagerung der 3dimensionalen Bilddatensätze aller Bauteile der zu kompensierenden Hardwarekomponenten zu einer Abschwächungskorrekturkarte,
(2.b2) Erzeugen einer Gesamt-Abschwächungskorrekturkarte mittels mathematischer Überlagerung der Abschwächungskorrekturkarte(n) aus Schritt (2.b1) mit der Abschwächungskorrekturkarte aus Schritt (2.a2)
(2.c1) Erzeugung von Emissionstomographie-Messdaten durch Aufnahme des zu untersuchenden Objekts im Emissionstomographen ,
(2.c2) Ausführen einer Emissionstomographie-Bildrekonstruktion der in Schritt
(2.c1) gewonnenen Messdaten unter Einbeziehung der Gesamt-Abschwächungskorrekturkarte aus Schritt (2.b2).

Der Datensatz sollte die Anatomie bzw. Struktur des Objekts wiedergeben. Dies kann vorzugsweise ein tomographisches Bild sein. Das tomographische Bild muss aber nicht unbedingt ein MRI Bild sein, es kann beispielsweise auch aus anderen tomographischen Verfahren, wie zum Photonentransmissionsverfahren, wie zum Beispiel CT, kommen. Außerdem sollte sich das zu untersuchende Objekt beim Aufnahmeschritt (2.a2) in einer definierten räumlichen Position befinden.

Die oben zitierte Referenz [4] beschreibt demgegenüber ein Verfahren zur Durchführung einer Gesamt-Abschwächungskorrektur von Emissionstomographie-Bilddatensätzen mit folgenden Schritten: Aufnahme eines 3dimensionalen tomographischen Datensatzes eines zu untersuchenden Objekts, Erzeugung einer Abschwächungskorrekturkarte aus dem 3dimensionalen tomographischen Datensatz, Bereitstellen einer oder mehrerer Abschwächungskorrekturkarten, Erzeugen einer Gesamt-Abschwächungskorrekturkarte mittels mathematischer Überlagerung der Abschwächungskorrekturkarte(n), Erzeugung von Emissionstomographie-Messdaten durch Aufnahme des zu untersuchenden Objekts im Emissionstomographen, Ausführen einer Emissionstomographie-Bildrekonstruktion der Messdaten unter Einbeziehung der Gesamt-Abschwächungskorrekturkarte.

Ein ähnliches Verfahren ist auch aus WO 2010/097714 (=Referenz [4a]) bekannt.

Bei vorteilhaften Varianten dieser Klasse von Ausführungsformen wird vor Schritt (2.b2) die relative Position der in Schritt (2.b1) und (2.a2) erhaltenen Abschwächungskorrekturkarten zueinander bestimmt und die Gesamt-Abschwächungskorrekturkarte in Schritt (2.b2) unter Einbeziehung der Positionsinformationen aller Karten erzeugt. Dies erhöht die Genauigkeit.

Besonders bevorzugt sind Weiterbildungen dieser Klasse von Ausführungsformen, bei welchen die Generierung der Gesamt-Abschwächungskarte gestützt wird durch eine automatische Erkennung der Hardwarekomponenten. Damit wird die Fehleranfälligkeit stark reduziert.

Weitere Varianten des erfindungsgemäßen Verfahrens zeichnen sich dadurch aus, dass die Abschwächungskorrekturkarte des Objekts in Schritt (2.a2) mittels eines Segmentierungsverfahrens basierend auf MRI-Bilddaten bestimmt wird. Vorteilhafterweise zeigen die MRI-Aufnahmen insbesondere einen Weichteilkontrast und können mit Messmethoden der Emissionstomographie kombiniert werden.

Vorteilhaft sind auch Weiterbildungen dieser Varianten des erfindungsgemäßen Verfahrens, bei welchen das Segmentierungsverfahren folgende Unterschritte umfasst:
(2.a3) Zuordnen von Bereichen des MRI-Bildes zu bekannten Materialtypen, insbesondere Gewebetypen, insbesondere aufgrund von Informationen aus einer Datenbank,
(2.a4) Zuordnen der gefundenen Materialtypen zu spezifischen Abschwächungskoeffizienten, insbesondere aufgrund von Informationen aus einer Datenbank,
(2.a5) Erstellen einer materialspezifischen Abschwächungskarte des zu untersuchenden Objekts aufgrund des aufgenommenen MRI-Bildes.

Derartige Segmentierungsverfahren haben das Potenzial, eine hohe Genauigkeit bei der Erstellung der Abschwächungskarte zu erreichen. Nachteilig kann sich allerdings auswirken, dass sich eine vollautomatische Segmentierung, die völlig ohne Benutzerinteraktion auskommt, umso schwieriger gestaltet, je höher die Anzahl an Segmenten ist.

Weitere vorteilhafte Varianten der oben beschriebenen Klasse von Ausführungsformen sind dadurch gekennzeichnet, dass die Abschwächungskorrekturkarte des Objekts mittels eines Atlas-basierten Verfahrens gestützt auf MRI-Bilddaten bestimmt wird.

Vorzugsweise sind beim Atlas-basierten Verfahren mehrere Datensätze eines Objekts in einer Bibliothek hinterlegt, welche mit einer Abschwächungskorrekturkarte ausgestattet sind. Aus dieser Bibliothek wird der Datensatz ausgewählt, der dem Bilddatensatz am nächsten kommt. Eine mögliche Ausführungsform besteht darin, jeden Datensatz der Bibliothek durch geeignete geometrische Verzerrung zunächst möglichst gut zur Deckung mit dem Bilddatensatz zu bringen. Der Grad an Übereinstimmung wird für jeden Datensatz quantifiziert. Schließlich wird jener Datensatz selektiert, der die größte Übereinstimmung besitzt. Die zugehörige Abschwächungskorrekturkarte wird derselben geometrischen Verzerrung wie der Datensatz unterzogen. Diese stellt dann die abschließend verwendete Abschwächungskorrekturkarte des Objekts dar.

Vorteil: Atlas-basierte Verfahren, mit welchen die aktuell gemessenen Bilddatensätze auf bereits vorhandene Datensätze, etwa aus einer entsprechenden Bibliothek angepasst werden, erfordern einen geringeren technischen Aufwand.

Nachteil: Für das zu untersuchende Objekt muss eine geeignete Abschwächungskarte (also mit hoher Übereinstimmung der Struktur bzw. Morphologie) in der Datenbank überhaupt vorhanden sein.

Dazu alternative Verfahrens-Varianten zeichnen sich dadurch aus, dass die Abschwächungskorrekturkarte des Objekts mittels einer Photonen-Transmissionsmessung bestimmt wird. Dabei kann die Photonen-Quelle eine Röntgenquelle oder ein radioaktiver Gamma-Strahler sein, was vorteilhaft eine direkte Messung der Abschwächungskoeffizienten ermöglicht.

### Das erfindungsgemäße System

In den Rahmen der vorliegenden Erfindung fällt auch eine kombinierte Emissionstomographie-Apparatur gemäß Anspruch 10. Sie umfasst ein Gerät zur Aufnahme 3dimensionaler tomographischer Datensätze eines zu untersuchenden Objekts
sowie ein Emissionstomographie-Gerät mit einer definierten Anordnung von Detektorelementen zur Detektion kinetischer Parameter von aus einem Messvolumen emittierter Photonen,
wobei die kombinierte Apparatur eingerichtet ist zur sequentiellen oder simultanen Aufnahme sowohl eines 3dimensionalen tomographischen Datensatzes als auch eines Emissionstomographie-Bildes desselben zu untersuchenden Objekts in einer jeweils definierten Mess-Positionen innerhalb der kombinierten -Apparatur,
welche dadurch gekennzeichnet ist,
dass die kombinierten Apparatur eingerichtet ist zum Durchführen einer Gesamt-Abschwächungskorrektur von Emissionstomographie-Bilddatensätzen mittels einer Variante des oben beschriebenen erfindungsgemäßen Verfahrens gekennzeichnet durch folgende Schritte:
(2.a1) Aufnahme eines 3dimensionalen tomographischen Datensatzes eines zu untersuchenden Objekts,
(2.a2) Erzeugung einer Abschwächungskorrekturkarte aus dem in Schritt (2.a1) erhaltenen 3dimensionalen tomographischen Datensatz
(2.b1) Bereitstellen einer oder mehrerer gemäß Anspruch 1 oder 2 gewonnener Abschwächungskorrekturkarten zur Kompensation von Bildfehlern in der Emissionstomographie aufgrund vorhandener Hardwarekomponenten innerhalb des Bildgebungsvolumens eines Emissionstomographen, umfassend folgende Schritte:
   (1.a) Anfertigen oder Bereitstellen eines oder mehrerer 3dimensionaler CAD-Modelle der zu kompensierenden Hardwarekomponenten,
   (1.b) Konvertierung der benötigten Bauteile der CAD-Modelle in einen 3dimensionalen Bilddatensatz auf einem vorgegebenen Gitter zu Voxeln und Zuordnen eines Füllfaktors zu jedem Voxel,
   (1.c) Punktweise Multiplikation des 3dimensionalen Bilddatensatzes eines jeden Bauteils mit dem jeweiligen bekannten Abschwächungskoeffizienten desjenigen Materials, aus dem das jeweilige Bauteil aufgebaut ist und derjenigen Energie, die der des verwendeten Emissionstomographie-Radiotracers entspricht; und
   (1.d) Überlagerung der 3dimensionalen Bilddatensätze aller Bauteile der zu kompensierenden Hardwarekomponenten zu einer Abschwächungskorrekturkarte,
(2.b2) Erzeugen einer Gesamt-Abschwächungskorrekturkarte mittels mathematischer Überlagerung der Abschwächungskorrekturkarte(n) aus Schritt (2.b1) mit der Abschwächungskorrekturkarte aus Schritt (2.a2)
(2.c1) Erzeugung von Emissionstomographie-Messdaten durch Aufnahme des zu untersuchenden Objekts im Emissionstomographen,
(2.c2) Ausführen einer Emissionstomographie-Bildrekonstruktion der in Schritt (2.c1) gewonnenen Messdaten unter Einbeziehung der Gesamt-Abschwächungskorrekturkarte aus Schritt (2.b2).

Vorzugsweise umfasst die kombinierte Emissionstomographie-Apparatur eine Datenbank, welche die Abschwächungskorrekturkarten der gebräuchlichen Hardwarekomponenten beinhaltet. Eine Steuereinrichtung ist während des Betriebs so eingerichtet bzw. programmiert, dass die jeweils passenden Abschwächungskorrekturkarten der im Betrieb aktuell verwendeten Hardwarekomponenten selektiert werden und der -beispielsweise mittels CT oder MRT gemessenen- Abschwächungskorrekturkarte in geeigneter Weise überlagert werden kann.

Besonders bevorzugt ist eine Ausführungsform dieser kombinierten Emissionstomographie-Apparatur, bei welcher das Gerät zur Aufnahme 3dimensionaler tomographischer Datensätze ein MRI-Gerät ist, umfassend einen Magneten zur Erzeugung eines homogenen NMR-Magnetfelds B₀ in einem Messvolumen, ein Gradientenspulensystem zur Erzeugung von Magnetfeldgradienten im Messvolumen, und ein Hochfrequenz-Anregungs- und Lesespulensystem zum Einstrahlen von Hochfrequenz-Pulsen in das Messvolumen und zum Auslesen des Messvolumens. Wie bereits oben erläutert, bringt die MRI Weichteilkontraste und kann mit einer Vielzahl verschiedener Messmethoden der Emissionstomographie kombiniert werden.

Eine dazu alternative Ausführungsform der kombinierten Emissions-tomographie-Apparatur schließlich zeichnet sich dadurch aus, dass das Gerät zur Aufnahme 3dimensionaler tomographischer Datensätze ein Computertomographiegerät ist, umfassend eine Röntgenquelle und eine Detektoreinheit, welche derart zueinander beweglich, vorzugsweise rotierbar, angeordnet sind, dass ein 3dimensionaler Datensatz eines zu untersuchenden Objekts, welches zwischen Röntgenquelle und Detektoreinheit positioniert ist, aufgenommen werden kann. Dabei ist von besonderem Vorteil, dass die Kombination PET/CT ein komplementäres Kontrastverhalten zur Kombination PET/MRT aufweist, so dass beide Ausführungsformen unterschiedliche Anwendungsbereiche abdecken.

Prinzipiell kann der gewünschte Datensatz auch mittels anderer Photonentransmissionsverfahren aufgenommen werden. Im Stand der Technik sind beispielsweise auch Verfahren bekannt, die im Wesentlichen identisch zur CT sind, wobei aber die Röntgenquelle durch einen radioaktiven Gamma-Strahler ersetzt ist. Besonders vorteilhaft ist das beschriebene Verfahren zur Erstellung einer Gesamt-Abschwächungskorrekturkarte aber für die Kombination MRI und PET, da mittels der MRT die direkte Bestimmung von Abschwächungskoeffizienten nicht möglich ist.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Darstellung des erfindungsgemäßen Verfahrens zur Erstellung einer Abschwächungskorrekturkarte, hier für eine aus mehreren Einzel-Bauteilen zusammengesetzte Hardwarekomponente, mittels 3dimensionaler CAD-Daten;
- Fig. 2: eine detailliertere Darstellung des Voxelisierungsschritts aus Ebene 3 des Ablaufschema von Fig. A beispielhaft an einem fiktiven, schematischen Bauteil in Form einer Sechskantmutter; und
- Fig. 3: eine schematische Längsschnitt-Darstellung der wesentlichen Bestandteile eines kombinierten PET-MRI-Systems nach dem **Stand der Technik,** auf welchem das erfindungsgemäße Verfahren durchgeführt werden kann.

### Überblick über die Erfindung

Kernstück der vorliegenden Erfindung ist ein Verfahren zur Erzeugung einer Abschwächungskorrekturkarte zur Kompensation von Bildfehlern in der Emissionstomographie aufgrund vorhandener Hardwarekomponenten innerhalb des Bildgebungsvolumens eines Emissionstomographen. Insbesondere dient das erfindungsgemäße Verfahren der verbesserten Nutzung einer kombinierten Emissionstomographie-Apparatur, die außer einem Emissionstomographie-Gerät auch noch mindestens ein Gerät zur Aufnahme 3dimensionaler tomographischer Datensätze eines zu untersuchenden Objekts umfasst.

Ziel der Erfindung ist die Erstellung einer hochgradig genauen, möglichst rauschfreien und exakt reproduzierbaren Schwächungskorrekturkarte für eine Schwächungskorrektur bei dem Emissionstomographie-Gerät unter Berücksichtigung der tatsächlich vorhandenen, bekannten HardwareKomponenten der Apparatur, welche einen wesentlichen Einfluss auf die Qualität der erzeugten Tomogramme haben.

Dazu werden mittels des erfindungsgemäßen Verfahrens folgende Schritte durchgeführt:
(1.a) Anfertigen oder Bereitstellen eines oder mehrerer 3dimensionaler CAD-Modelle der zu kompensierenden Hardwarekomponenten,
(1.b) Konvertierung der benötigten Bauteile der CAD-Modelle in einen 3dimensionalen Bilddatensatz auf einem vorgegebenen Gitter zu Voxeln und Zuordnen eines Füllfaktors zu jedem Voxel,
(1.c) Punktweise Multiplikation des 3dimensionalen Bilddatensatzes eines jeden Bauteils mit dem jeweiligen bekannten Abschwächungskoeffizienten desjenigen Materials, aus dem das jeweilige Bauteil aufgebaut ist und derjenigen Energie, die der des verwendeten Emissionstomographie-Radiotracers entspricht; und
(1.d) Überlagerung der 3dimensionalen Bilddatensätze aller Bauteile der zu kompensierenden Hardwarekomponenten zu einer Abschwächungskorrekturkarte.

Bei dem Konvertierungsschritt (1.b) können die Bauteile zur Verminderung des Rechenaufwandes und damit zur Erhöhung der Schnelligkeit des Verfahrens in einem Zwischenschritt trianguliert werden.

Die erfindungsgemäß erzeugte Abschwächungskorrekturkarte kann dann in einem Verfahren zur Durchführung einer Gesamt-Abschwächungskorrektur von Emissionstomographie-Bilddatensätzen mit folgenden Schritten eingesetzt werden:
(2.a1) Aufnahme eines 3dimensionalen tomographischen Datensatzes eines zu untersuchenden Objekts,
(2.a2) Erzeugung einer Abschwächungskorrekturkarte aus dem in Schritt (2.a1) erhaltenen 3dimensionalen tomographischen Datensatz
(2.b1) Bereitstellen einer oder mehrerer gemäß Anspruch 1 oder 2 gewonnener Abschwächungskorrekturkarten,
(2.b2) Erzeugen einer Gesamt-Abschwächungskorrekturkarte mittels mathematischer Überlagerung der Abschwächungskorrekturkarte(n) aus Schritt (2.b1) mit der Abschwächungskorrekturkarte aus Schritt (2.a2)
(2.c1) Erzeugung von Emissionstomographie-Messdaten durch Aufnahme des zu untersuchenden Objekts im Emissionstomographen,
(2.c2) Ausführen einer Emissionstomographie-Bildrekonstruktion der in Schritt (2.c1) gewonnenen Messdaten unter Einbeziehung der Gesamt-Abschwächungskorrekturkarte aus Schritt (2.b2).

Vorzugsweise wird vor Schritt (2.b2) die relative Position der in Schritt (2.b1) und (2.a2) erhaltenen Abschwächungskorrekturkarten zueinander bestimmt und die Gesamt-Abschwächungskorrekturkarte in Schritt (2.b2) unter Einbeziehung der Positionsinformationen aller Karten erzeugt. Die Generierung der Gesamt-Abschwächungskarte kann auf eine automatische Erkennung der Hardwarekomponenten gestützt werden.

### Schematische bildliche Darstellung der erfindungsgemäßen Verfahrensschritte

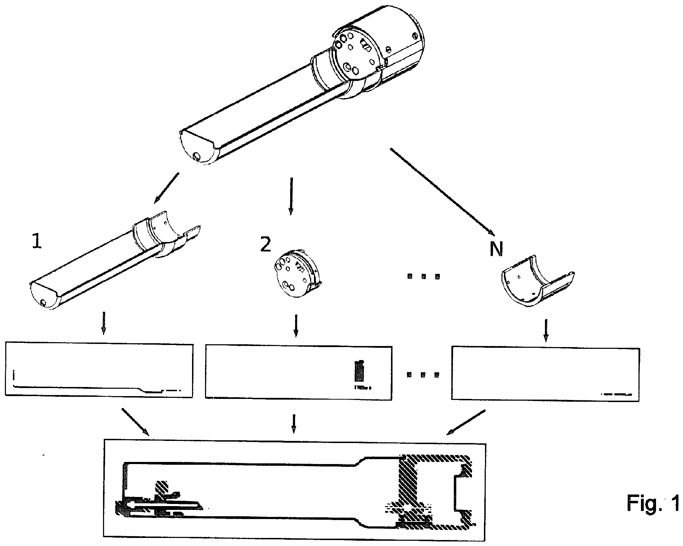

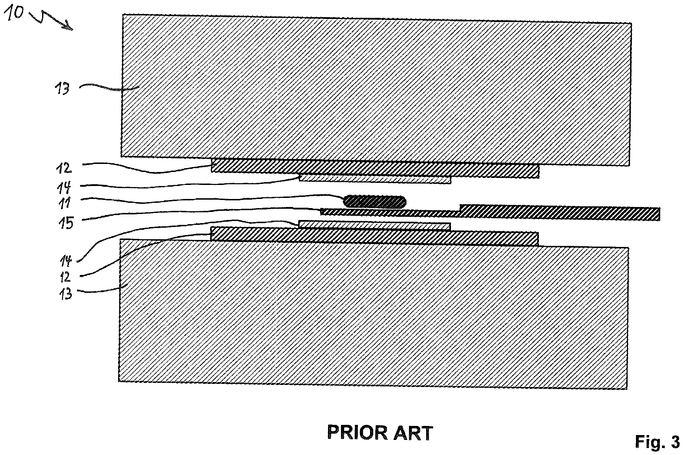

Ausgangspunkt des in **Fig. 1** sehr schematisch gezeigten erfindungsgemäßen Verfahrens ist eine -natürlich als solche *nicht* dargestellte- CAD-Datei der in der obersten 1. Ebene der Figur 3 dimensional dargestellten Hardware-Komponente, im vorliegenden Beispiel eine Liege für die Lagerung eines Versuchstieres während der tomographischen Messungen.

In der 2. Ebene der Figur 1 ist angedeutet, wie diese Hardware-Komponente -gedanklich- in ihre N bekannten Einzel-Bauteile 1, 2, ... N zerlegt wird.

Jedes Einzel-Bauteil wird rechnerisch in eine Abschwächungskarte konvertiert, also voxelisiert, wie man in der 3. Ebene von Fig. 1 erkennt. Allerdings werden aus Gründen der Übersichtlichkeit der Darstellung in dieser 3. Ebene lediglich 1dimensionale Voxel-Bilder gezeigt. In der Realität sind die entsprechenden Datensätze jedoch 3dimensional.

Anschließend werden alle Abschwächungskarten der N Einzel-Bauteile zu einer Gesamtabschwächungskarte der gesamten Hardware-Komponente überlagert, was in der 4. Ebene von Fig. 1 -ebenfalls wieder nur 1dimensional- angedeutet ist.

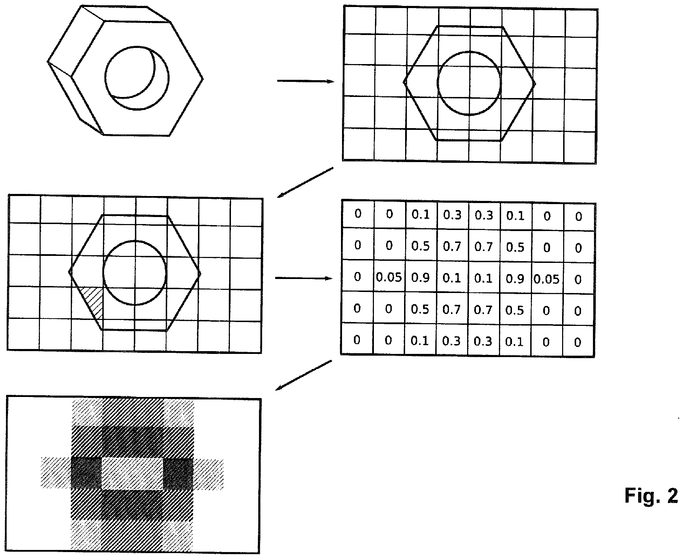

**Fig. 2** zeigt eine detailliertere Darstellung des Voxelisierungsschritts aus Ebene 3 des Ablaufschemas von Fig. 1 beispielhaft an einem fiktiven, schematischen Bauteil (im vorliegenden Beispiel einer fiktiven Sechskantmutter, wie sie im 1. Bild von Fig. 2 angedeutet ist). Zur einfacheren Darstellung ist der Prozess 2dimensional in einer Schnittebene des 3dimensionalen Bauteils gezeigt.

Dem Bauteil wird rechnerisch ein 3dimensionales Gitter überlagert (siehe 2. Bild von Fig. 2).

Die durch das Gitter definierten Voxel haben jeweils einen Füllfaktor zwischen 0 und 1 der den "Überlappungsgrad" mit dem Bauteil angibt. Im 3. Bild von Fig. 2 ist dies beispielhaft für ein beliebiges Voxel gezeigt.

Für jedes Voxel wird der Füllfaktor bestimmt. Man erhält damit eine vollständige 3dimensionale Füllfaktor-Karte des Bauteils (angedeutet im 4. Bild von Fig. 2).

Durch punktweise Multiplikation der gesamten Füllfaktor-Karte mit dem Abschwächungskoeffizienten des Materials, aus welchem das Bauteil besteht, ergibt sich die Abschwächungskarte des Bauteils (schematisch dargestellt in den schraffierten Graustufen im 5. und letzten Bild von Fig. 2).

**Fig. 3** schließlich zeigt eine schematische Längsschnitt-Darstellung eines kombinierten PET-MRI-Systems nach dem Stand der Technik, welches zur Durchführung des erfindungsgemäßen Verfahrens dienen kann. Die in Fig. 3 gezeigte **kombinierte Emissionstomographie-Apparatur 10** umfasst ein Gerät zur Aufnahme 3dimensionaler tomographischer Datensätze eines **zu untersuchenden Objekts 11** sowie ein **Emissionstomographie-Gerät 12** mit einer definierten Anordnung von Detektorelementen zur Detektion kinetischer Parameter von aus einem Messvolumen emittierter Photonen. Die kombinierte Apparatur 10 ist eingerichtet ist zur sequentiellen oder simultanen Aufnahme sowohl eines 3dimensionalen tomographischen Datensatzes als auch eines Emissionstomographie-Bildes desselben zu untersuchenden Objekts 11 in einer jeweils definierten Mess-Positionen innerhalb der kombinierten Apparatur 10.

Die Komponenten des in Fig. 3 zylindersymmetrischen Geräts -von radial innen nach außen- enthalten a) ein auf einer **Liege 15** beziehungsweise einem Auflageschlitten positioniertes Messobjekt 11, b) ein **HF-Anregungs- und Lesespulensystem 14** eines MRI-Geräts zur Erzeugung eines homogenen NMR-Magnetfelds B₀ im Messvolumen und zur Detektion des MR-Signals, c) ein Emissionstomographie-Gerät 12, etwa eine PET-Anordnung, sowie d) ein **MRT-Magnetsystem 13** inklusive eines nicht eigens dargestellten Gradientenspulensystems zur Erzeugung von Magnetfeldgradienten im Messvolumen.

### Bezugszeichenliste

- 10: kombinierte Emissionstomographie-Apparatur
- 11: zu untersuchendes Objekt
- 12: Emissionstomographie-Gerät
- 13: NMR-Magnet
- 14: HF-Anregungs- und Lesespulensystem
- 15: Liege
- 1, 2, ... N: Einzel-Bauteile

### Referenzliste

[1] US 2014/0221817 A1
[2] US 8,724,875 B2
[3] DE 10 2010 024 139 A1
[4] DE 10 2007 044 874 A1
[4a] WO 2010/097714 A2
[5] DE 10 2012 214 012 A1

## Patentansprüche

1. Verfahren zur Erzeugung einer Abschwächungskorrekturkarte mittels eines Computers zur Kompensation von Bildfehlern in der Emissionstomographie aufgrund vorhandener Hardwarekomponenten innerhalb des Bildgebungsvolumens eines Emissionstomographen, umfassend folgende Schritte:
(1.a) Anfertigen oder Bereitstellen eines oder mehrerer 3dimensionaler CAD-Modelle der zu kompensierenden Hardwarekomponenten,
(1.b) Konvertierung der benötigten Bauteile der CAD-Modelle in einen 3dimensionalen Bilddatensatz auf einem vorgegebenen Gitter zu Voxeln und Zuordnen eines Füllfaktors zu jedem Voxel,
(1.c) Punktweise Multiplikation des 3dimensionalen Bilddatensatzes eines jeden Bauteils mit dem jeweiligen bekannten Abschwächungskoeffizienten desjenigen Materials, aus dem das jeweilige Bauteil aufgebaut ist und derjenigen Energie, die der des verwendeten Emissionstomographie-Radiotracers entspricht; und
(1.d) Überlagerung der 3dimensionalen Bilddatensätze aller Bauteile der zu kompensierenden Hardwarekomponenten zu einer Abschwächungskorrekturkarte.

2. Verfahren nach Anspruch 1, **dadurch gekennzeichnet, dass** die Bauteile in Schritt (1.b) in einem Zwischenschritt trianguliert werden.

3. Verfahren zur Durchführung einer Gesamt-Abschwächungskorrektur von Emissionstomographie-Bilddatensätzen mittels einer nach Anspruch 1 oder 2 erzeugten Abschwächungskorrekturkarte,
**gekennzeichnet durch** folgende Schritte:
(2.a1) Aufnahme eines 3dimensionalen tomographischen Datensatzes eines zu untersuchenden Objekts,
(2.a2) Erzeugung einer Abschwächungskorrekturkarte aus dem in Schritt (2.a1) erhaltenen 3dimensionalen tomographischen Datensatz (2.b1) Bereitstellen einer oder mehrerer gemäß Anspruch 1 oder 2 gewonnener Abschwächungskorrekturkarten zur Kompensation von Bildfehlern in der Emissionstomographie aufgrund vorhandener Hardwarekomponenten innerhalb des Bildgebungsvolumens eines Emissionstomographen, umfassend folgende Schritte:
(1.a) Anfertigen oder Bereitstellen eines oder mehrerer 3dimensionaler CAD-Modelle der zu kompensierenden Hardwarekomponenten,
(1.b) Konvertierung der benötigten Bauteile der CAD-Modelle in einen 3dimensionalen Bilddatensatz auf einem vorgegebenen Gitter zu Voxeln und Zuordnen eines Füllfaktors zu jedem Voxel,
(1.c) Punktweise Multiplikation des 3dimensionalen Bilddatensatzes eines jeden Bauteils mit dem jeweiligen bekannten Abschwächungskoeffizienten desjenigen Materials, aus dem das jeweilige Bauteil aufgebaut ist und derjenigen Energie, die der des verwendeten Emissionstomographie-Radiotracers entspricht; und
(1.d) Überlagerung der 3dimensionalen Bilddatensätze aller Bauteile der zu kompensierenden Hardwarekomponenten zu einer Abschwächungskorrekturkarte,
(2.b2) Erzeugen einer Gesamt-Abschwächungskorrekturkarte mittels mathematischer Überlagerung der Abschwächungskorrekturkarte(n) aus Schritt (2.b1) mit der Abschwächungskorrekturkarte aus Schritt (2.a2) (2.c1) Erzeugung von Emissionstomographie-Messdaten durch Aufnahme des zu untersuchenden Objekts im Emissionstomographen,
(2.c2) Ausführen einer Emissionstomographie-Bildrekonstruktion der in Schritt (2.c1) gewonnenen Messdaten unter Einbeziehung der Gesamt-Abschwächungskorrekturkarte aus Schritt (2.b2).

4. Verfahren nach Anspruch 3, **dadurch gekennzeichnet, dass** vor Schritt (2.b2) die relative Position der in Schritt (2.b1) und (2.a2) erhaltenen Abschwächungskorrekturkarten zueinander bestimmt und die Gesamt-Abschwächungskorrekturkarte in Schritt (2.b2) unter Einbeziehung der Positionsinformationen aller Karten erzeugt wird.

5. Verfahren nach Anspruch 3 oder 4, **dadurch gekennzeichnet, dass** die Generierung der Gesamt-Abschwächungskarte gestützt wird durch eine automatische Erkennung der Hardwarekomponenten.

6. Verfahren nach einem der Ansprüche 3 bis 5, **dadurch gekennzeichnet, dass** die Abschwächungskorrekturkarte des Objekts in Schritt (2.a2) mittels eines Segmentierungsverfahrens basierend auf MRI-Bilddaten bestimmt wird.

7. Verfahren nach Anspruch 6, wobei das Segmentierungsverfahren folgende Unterschritte umfasst:
(2.a3) Zuordnen von Bereichen des MRI-Bildes zu bekannten Materialtypen, insbesondere Gewebetypen, insbesondere aufgrund von Informationen aus einer Datenbank,
(2.a4) Zuordnen der gefundenen Materialtypen zu spezifischen PET-Abschwächungskoeffizienten, insbesondere aufgrund von Informationen aus einer Datenbank,
(2.a5) Erstellen einer materialspezifischen PET-Abschwächungskarte des zu untersuchenden Objekts aufgrund des aufgenommenen MRI-Bildes.

8. Verfahren nach einem der Ansprüche 3 bis 5, **dadurch gekennzeichnet, dass** die Abschwächungskorrekturkarte des Objekts mittels eines Atlas-basierten Verfahrens gestützt auf MRI-Bilddaten bestimmt wird.

9. Verfahren nach einem der Ansprüche 3 bis 5, **dadurch gekennzeichnet, dass** die Abschwächungskorrekturkarte des Objekts mittels einer Photonen-Transmissionsmessung bestimmt wird, ausgewählt aus CT, PET oder SPECT.

10. Kombinierte Emissionstomographie-Apparatur (10), umfassend ein Gerät zur Aufnahme 3dimensionaler tomographischer Datensätze eines zu untersuchenden Objekts (11)
sowie ein Emissionstomographie-Gerät (12) mit einer definierten Anordnung von Detektorelementen zur Detektion kinetischer Parameter von aus einem Messvolumen emittierter Photonen,
wobei die kombinierte Apparatur (10) eingerichtet ist zur sequentiellen oder simultanen Aufnahme sowohl eines 3dimensionalen tomographischen Datensatzes als auch eines Emissionstomographie-Bildes desselben zu untersuchenden Objekts (11) in einer jeweils definierten Mess-Positionen innerhalb der kombinierten Apparatur (10),
**dadurch gekennzeichnet,**
**dass** die kombinierten Apparatur (10) eingerichtet ist zum Durchführen einer Gesamt-Abschwächungskorrektur von Emissionstomographie-Bilddatensätzen mittels eines Verfahrens nach einem der Ansprüche 3 bis 9.

11. Kombinierte Emissionstomographie-Apparatur nach Anspruch 10, wobei das Gerät zur Aufnahme 3dimensionaler tomographischer Datensätze ein MRI-Gerät ist, umfassend einen Magneten (13) zur Erzeugung eines homogenen NMR-Magnetfelds B₀ in einem Messvolumen, ein Gradientenspulensystem zur Erzeugung von Magnetfeldgradienten im Messvolumen, und ein Hochfrequenz-Anregungs- und Lesespulensystem (14) zum Einstrahlen von Hochfrequenz-Pulsen in das Messvolumen und zum Auslesen des Messvolumens.

12. Kombinierte Emissionstomographie-Apparatur nach Anspruch 10, wobei das Gerät zur Aufnahme 3dimensionaler tomographischer Datensätze ein Computertomographiegerät ist, umfassend eine Röntgenquelle und eine Detektoreinheit, welche derart zueinander beweglich, vorzugsweise rotierbar, angeordnet sind, dass ein 3dimensionaler Datensatz eines zu untersuchenden Objekts, welches zwischen Röntgenquelle und Detektoreinheit positioniert ist, aufgenommen werden kann.

## Claims

1. A method to generate an attenuation correction map by means of a computer to compensate imaging errors in emission tomography resulting from the presence of hardware parts inside the imaging volume of an emission tomograph, comprising the following steps:
(1.a) preparing or providing one or more 3-dimensional CAD models of the hardware parts to be compensated;
(1.b) converting the required components of the CAD models into a 3-dimensional image data set into voxels on a predetermined grid and assigning a filling factor to each voxel;
(1.c) pointwise multiplying the 3-dimensional image data set of each component with the respective known attenuation coefficient of the material that forms the respective component and the respective energy corresponding to the emission tomography radio tracer used; and
(1.d) super-imposing the 3-dimensional image data sets of all components of the hardware parts to be compensated for to form an attenuation correction map.

2. Method according to claim 1, **characterized in that** in an intermediate step the parts in step (1.b) are triangulated.

3. A method to perform a total attenuation correction of emission tomography image data sets by means of an attenuation correction map generated according to claim 1 or claim 2,
**characterized by** the following steps:
(2.a1) recording a 3-dimensional tomographic data set of an object to be investigated,
(2.a2) generating an attenuation correction map from the 3-dimensional tomographic data set as obtained in step (2.a1),
(2.b1) providing one or more attenuation correction maps obtained according to claim 1 or claim 2 for compensating imaging errors in emission tomography resulting from the presence of hardware parts inside the imaging volume of an emission tomograph, comprising the following steps:
(1.a) preparing or providing one or more 3-dimensional CAD models of the hardware parts to be compensated;
(1.b) converting the required components of the CAD models into a 3-dimensional image data set into voxels on a predetermined grid and assigning a filling factor to each voxel;
(1.c) pointwise multiplying the 3-dimensional image data set of each component with the respective known attenuation coefficient of the material that forms the respective component and the respective energy corresponding to the emission tomography radio tracer used; and
(1.d) super-imposing the 3-dimensional image data sets of all components of the hardware parts to be compensated for to form an attenuation correction map,(2.b2) generating a total attenuation correction map by means of mathematical superposition of the attenuation correction map(s) of step (2.b1) with the attenuation correction map of step (2.a2),
(2.c1) generating emission tomography measuring data by means of recording the object to be investigated in the emission tomograph,
(2.c2) performing an emission tomography image reconstruction of the measuring data obtained in step (2.c1) by taking into account the total attenuation correction map of step (2.b2).

4. Method according to claim 3, **characterized in that** prior to step (2.b2) the relative position of the attenuation correction maps to each other obtained in steps (2.b1) and (2.a2) is determined and the total attenuation correction map is generated in step (2.b2) taking into account the position information of all maps.

5. Method according to claim 3 or 4, **characterized in that** the generation of the total attenuation map is supported by an automatic recognition of the hardware parts.

6. Method according to one of claims 3 to 5, **characterized in that** in step (2.a2) the attenuation correction map of the object is determined by means of a segmentation method based on MRI image data.

7. Method according to claim 6, wherein the segmentation method comprises the following sub-steps:
(2.a3) assignment of ranges of the MRI image to known types of material, in particular tissue types, particularly based on information from a data base,
(2.a4) assignment of the identified types of material to specific PET attenuation coefficients, in particular based on information from a data base,
(2.a5) generation of a material specific PET attenuation map of the object to be investigated based on the recorded MRI image.

8. Method according to one of claims 3 to 5, **characterized in that** the attenuation correction map of the object is determined by means of an atlas-based method relying on MRI image data.

9. Method according to one of claims 3 to 5, **characterized in that** the attenuation correction map of the object is determined by means of a photon transmission measurement, selected from CT, PET or SPECT.

10. A combined emission tomography apparatus (10) comprising
a device for recording 3-dimensional tomographic data sets of an object (11) to be investigated, as well as
an emission tomography device (12) with a defined arrangement of detector elements to detect kinetic parameters of photons emitted out of a measuring volume,
wherein the combined apparatus (10) is equipped to sequentially or simultaneously record a 3-dimensional tomographic data set as well as an emission tomography image of the same object (11) to be investigated, each in a defined measuring position within the combined apparatus (10),
**characterized in that**
the combined apparatus (10) is equipped to perform a total attenuation correction of emission tomography image data sets by means of a method according to one of claims 3 to 9.

11. A combined emission tomography apparatus according to claim 10, wherein the device for recording 3-dimensional tomographic data sets is an MRI device comprising a magnet (13) to generate a homogeneous NMR magnetic field B₀ in a measuring volume, a gradient coil system to generate magnetic field gradients inside the measuring volume, and a high frequency excitation and detection coil system (14) to irradiate high frequency pulses into the measuring volume and to read-out the measuring volume.

12. A combined emission tomography apparatus according to claim 10, wherein the device for recording 3-dimensional tomographic data sets is a computer tomography device, comprising an x-ray source and a detector unit, which are arranged movably, preferably rotatably, with respect to each other in such a way that a 3-dimensional data set of an object to be investigated positioned between x-ray source and detector unit may be recorded.

## Revendications

1. Procédé de génération d'une carte de correction d'atténuation au moyen d'un ordinateur pour compenser des erreurs d'image en tomographie par émission dues à des composants matériels présents dans le volume d'imagerie d'un tomographe à émission, le procédé comprenant les étapes suivantes :
(1.a) produire ou fournir un ou plusieurs modèles CAO tridimensionnels des composants matériels à compenser,
(1.b) convertir les éléments structurels requis des modèles CAO en un ensemble de données d'image tridimensionnel sur une grille spécifiée pour former des voxels et associer un facteur de remplissage à chaque voxel,
(1.c) multiplier point par point l'ensemble de données d'image tridimensionnel de chaque élément structurel par le coefficient d'atténuation connu respectif du matériau, dont l'élément structurel respectif est constitué, et par l'énergie qui correspond à celle du traceur radio de tomographie d'émission utilisé ; et
(1.d) superposer les ensembles de données d'image tridimensionnels de tous les composants des composants matériels à compenser pour former une carte de correction d'atténuation.

2. Procédé selon la revendication 1, **caractérisé en ce que** les éléments structurels sont triangulés à l'étape (1.b) dans une étape intermédiaire.

3. Procédé de réalisation d'une correction d'atténuation totale d'ensembles de données d'image de tomographie d'émission au moyen d'une carte de correction d'atténuation générée selon la revendication 1 ou 2,
le procédé étant **caractérisé par** les étapes suivantes :
(2.a1) enregistrer un ensemble de données tomographiques tridimensionnel d'un objet à examiner,
(2.a2) générer une carte de correction d'atténuation de l'ensemble de données tomographiques tridimensionnel obtenu à partir de l'étape (2.a1),
(2.b1) fournir une ou plusieurs cartes de correction d'atténuation obtenues selon la revendication 1 ou 2 pour compenser les erreurs d'image dans la tomographie par émission dues aux composants matériels présents dans le volume d'imagerie d'un tomographe à émission, le procédé comprenant les étapes suivantes :
(1.a) produire ou fournir un ou plusieurs modèles CAO tridimensionnels des composants matériels à compenser,
(1.b) convertir les éléments structurels requis des modèles CAO dans un ensemble de données d'image tridimensionnel sur une grille spécifiée en voxels et associer un facteur de remplissage à chaque voxel,
(1.c) multiplier point par point l'ensemble de données d'image tridimensionnel de chaque éléments structurel par le coefficient d'atténuation connu respectif du matériau, dont l'élément structurel respectif est constitué, et par l'énergie qui correspond à celle du traceur radio de tomographie d'émission utilisé ; et
(1.d) superposer les ensembles de données d'image tridimensionnels de tous les éléments structurels des composants matériels à compenser pour former une carte de correction d'atténuation,
(2.b2) générer une carte de correction d'atténuation totale par superposition mathématique de la carte ou des cartes de correction d'atténuation de l'étape (2.b1) à la carte de correction d'atténuation de l'étape (2.a2), (2.c1) générer des données de mesure de tomographie d'émission par enregistrement de l'objet à examiner dans le tomographe d'émission,
(2.c2) réaliser une reconstruction d'image de tomographie d'émission des données de mesure obtenues à l'étape (2.c1) en prenant en compte la carte de correction d'atténuation totale de l'étape (2.b2).

4. Procédé selon la revendication 3, **caractérisé en ce que** la position relative des cartes de correction d'atténuation obtenues à l'étape (2.b1) et à l'étape (2.a2) est déterminée avant l'étape (2.b2) et la carte de correction d'atténuation totale est générée à l'étape (2.b2) en prenant en compte les informations de position de toutes les cartes.

5. Procédé selon la revendication 3 ou 4, **caractérisé en ce qu'**une détection automatique des composants matériels vient en appui de la génération de la carte d'atténuation totale.

6. Procédé selon l'une des revendications 3 à 5, **caractérisé en ce que** la carte de correction d'atténuation de l'objet est déterminée à l'étape (2.a2) au moyen d'un procédé de segmentation sur la base des données d'image IRM.

7. Procédé selon la revendication 6, le procédé de segmentation comprenant les sous-étapes suivantes :
(2.a3) associer des zones de l'image IRM à des types de matériaux connus, en particulier des types de tissu, en particulier sur la base d'informations provenant d'une base de données,
(2.a4) associer les types de matériau trouvés à des coefficients d'atténuation PET spécifiques, en particulier sur la base d'informations provenant d'une base de données,
(2.a5) établir une carte d'atténuation PET, spécifique au matériau, de l'objet à examiner sur la base de l'image IRM enregistrée.

8. Procédé selon l'une des revendications 3 à 5, **caractérisé en ce que** la carte de correction d'atténuation de l'objet est déterminée au moyen d'un procédé à base d'atlas s'appuyant sur des données d'image IRM.

9. Procédé selon l'une des revendications 3 à 5, **caractérisé en ce que** la carte de correction d'atténuation de l'objet est déterminée au moyen d'une mesure de transmission de photons, choisie parmi CT, PET et SPECT.

10. Appareil de tomographie d'émission combiné (10), comprenant
un dispositif d'enregistrement d'ensembles de données tomographiques tridimensionnels d'un objet à examiner (11),
et un dispositif de tomographie d'émission (12) muni d'un agencement défini d'éléments détecteurs destinés à la détection de paramètres cinétiques de photons émis à partir d'un volume de mesure,
l'appareil combiné (10) étant conçu pour enregistrer séquentiellement ou simultanément aussi bien un ensemble de données tomographiques tridimensionnel qu'une image de tomographie d'émission du même objet à examiner (11) dans une position de mesure respectivement définie à l'intérieur de l'appareil combiné (10),
**caractérisé en ce que**,
l'appareil combiné (10) est conçu pour effectuer une correction d'atténuation totale d'ensembles de données d'images de tomographie d'émission au moyen d'un procédé selon l'une des revendications 3 à 9.

11. Appareil de tomographie d'émission combiné selon la revendication 10, le dispositif d'enregistrement d'ensembles de données tomographiques tridimensionnelles étant un dispositif IRM, comprenant un aimant (13) destiné à générer un champ magnétique RMN homogène B₀ dans un volume de mesure, un système de bobine à gradient destiné à générer des gradients de champ magnétique dans le volume de mesure, et un système de bobines d'excitation et de lecture à haute fréquence (14) destiné à rayonner des impulsions à haute fréquence dans le volume de mesure et à lire le volume de mesure.

12. Appareil de tomographie d'émission combiné selon la revendication 10, le dispositif d'enregistrement d'ensembles de données tomographiques tridimensionnels étant un dispositif de tomographie par ordinateur comprenant une source de rayons X et une unité de détection, lesquelles sont disposées de façon à être mobiles, de préférence en rotation, l'une par rapport à l'autre de façon à pouvoir enregistrer un ensemble de données tridimensionnel d'un objet à examiner, qui est positionné entre la source de rayons X et l'unité de détection.
